# EUROPEAN PATENT APPLICATION

(11) **EP 0 696 854 A1**
(43) Date of publication of application: **14.02.1996**
(21) Application number: 95111940.3
(22) Date of filing: 29.07.1995
(51) Int. Cl.: H04B 1/26, H04B 1/16

(54) **Broadcast receiver adapted for analog and digital signals**

(30) Priority: 08.08.1994 EP 94401828
(71) Applicant: THOMSON multimedia S.A., F-92400 Courbevoie (FR)
(72) Inventor: Boie, Werner, F-67100 Strasbourg (FR)
(74) Representative: Hartnack, Wolfgang, Dipl.-Ing.

(57) **Abstract**

Background:
Digital satellite TV broadcasting systems use an analog IF input followed by an analog QPSK-demodulator and analog lowpass filters prior to A/D conversion. Normally, two A/D converters would be required for digital demodulation of the in phase and of the quadrature component.

Gist of the Invention

A first IF frequency of about 2 GHZ and a second IF of about 140 MHz allows to demodulate FM signals of 27 MHz bandwidth. A subsequent local 70 MHz local oscillator is followed by a lowered resolution A/D converter operating at about 100 MHz sampling frequency in a subsampling mode. A single A/D converter (7) is required only and allows high quality FM demodulation.

Advantages

Allows multi-standard front-end architecture, architecture is suited for digital and analogue input signals, the possible net data rate around 40MBit/s is even higher than required for DirecTV.

## Description

The invention relates to a broadcast receiver according to the introductory part of claim 1.

Digital TV broadcasting systems that transmit TV signals in digital data form through DBS have been developed aiming at next generation TV systems in several countries. Concerning the transmission the QPSK modulation is one of the most effective digital modulation scheme for high frequency spectrum efficiency. Proposed digital QPSK demodulator are still foreseen to have an analog IF input followed by a quadrature demodulator with lowpass filters prior to the A/D converters for the in phase and quadrature phase component. This approach makes sense in that way that analog IF signals cannot be directly digitised today and that a frequency down-conversion is necessary, anyhow. But on the other hand a quadrature demodulator for a high IF frequency is also difficult to realize. Another important drawback of the outlined digital QPSK demodulator is that it needs two A/D converters with each a high power consumption.

Now direct IF sampling is becoming more cost effective than traditional analog signal processing in some radio applications and it seems that the point has been reached where a digital solution for video IF signals should no longer be excluded in the satellite TV receiver design. This should also include the classical analog satellite reception with FM modulated signals.

It is an object of the invention to provide a broadcast receiver of the kind described which is suited for digital and analog input signals and using a common A/D converter only for analog and digital transmission via satellite.

According to the invention said IF signal is fed to a frequency down converter having its output connected to an A/D converter working with sub-sampling and having its output connected to an FM demodulator and a QPSK demodulator both working in digital signal processing technique.

The main advantages achieved by the present invention are the following:
The proposed architecture allows a digitising of the Sat-IF signals no matter that they are analog or digital ones. The robustness of the chosen modulation schemes allows further the application of an A/D-converter with reduced resolution at higher sampling frequencies in terms of usual video applications. Furthermore, there is only one A/D-converter necessary for the digitising instead of two or three for the classical solution which keeps the power consumption to a minimum. On the other hand by means of the digital signal processing the FM demodulation and also the QPSK demodulation can be realized with a high quality. The necessary analogue component count is nevertheless relatively small.

Nowadays, a multi-standard TV receiver should be able to function also as a satellite braodcast receiver. For that reason the outdoor unit supplies the satellite channels already down-converted in a frequency band covering 950 - 1750 MHz which should be handled by a multi-standard tuner. To take advantage of the double-conversion tuner the 1st-IF frequency should be around 2 GHz. In contrary to the terrestrial and cable transmission, the video signals are FM modulated (in case of the analog DBS transmission) and need, therefore, a significantly higher bandwidth, namely about 27 MHz according the approximation of he Carson formula. Consequently, the fixed bandpass filter in the 1st-IF circuit has to be enlarged by a factor between 2 and 3. If the assumed bandwidth is nearly tripled with respect to the terrestrial or cable reception, the 2nd-IF frequency should also be tripled to keep the relations. Otherwise, either the image frequency components on the 1st-IF band exert harmful influence on the system's performance or the necessary analogue filters become prohibitive expensive. Taking this statement into account, the 2nd-IF frequency should be in the order of 130 - 140 MHz. The assumed multi-standard tuner should, therefore, supply a second output for the 140 MHz Sat-IF signal.

In order that the invention might be better understood, the invention will now be described by using the accompanying drawing. In the drawing
- Fig. 1: shows a block diagram of a television receiver working according to the present invention; and
- Fig. 2: shows frequency spectra for the conversion of the analogue Sat-IF into a digital IF signal.

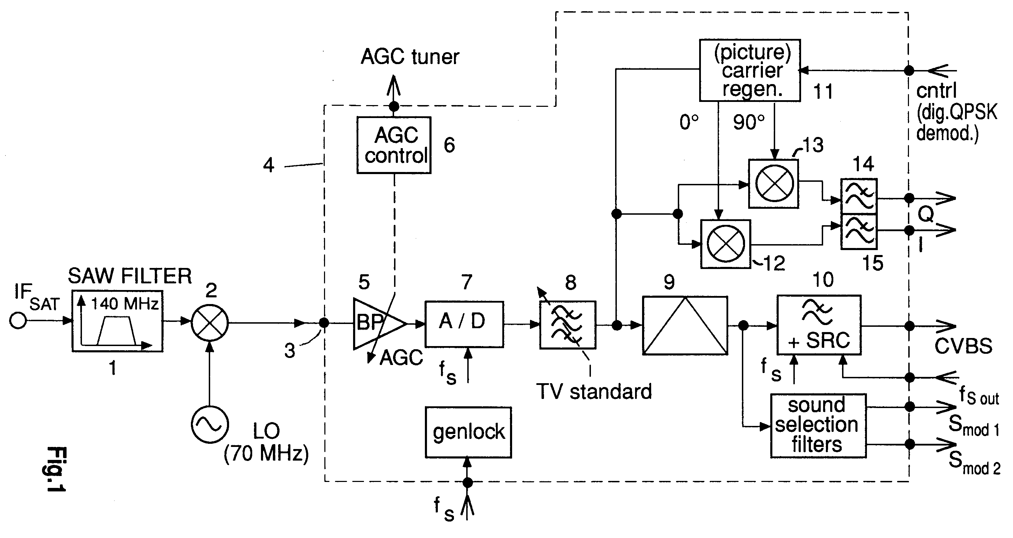

In Fig. 1 the incoming IF signal which may come from an outdoor station is fed to SAW(surface acoustic wave) filter 1 and then to a mixer 2 which is fed by oscillator LO having a frequency of 70 MHz. The frequency down-converted signal is fed to input 3 of circuit 4. Circuit 4 includes an amplifier 5 controlled in amplitude by AGC control circuit 6, an A/D converter 7 controlled by sampling frequency fs of 100 MHz, bandpass-filter 8, FM demodulator 9 and low pass filter 10 providing at it's output the CVBS signal. Further are provided a picture carrier regenerator 11 generating carriers with phase of 0° and 90° for QPSK demodulation, synchronous demodulators 12, 13 for QPSK quadrature demodulation and low pass filters 14, 15 providing signal Q,I at outputs of circuit 4.

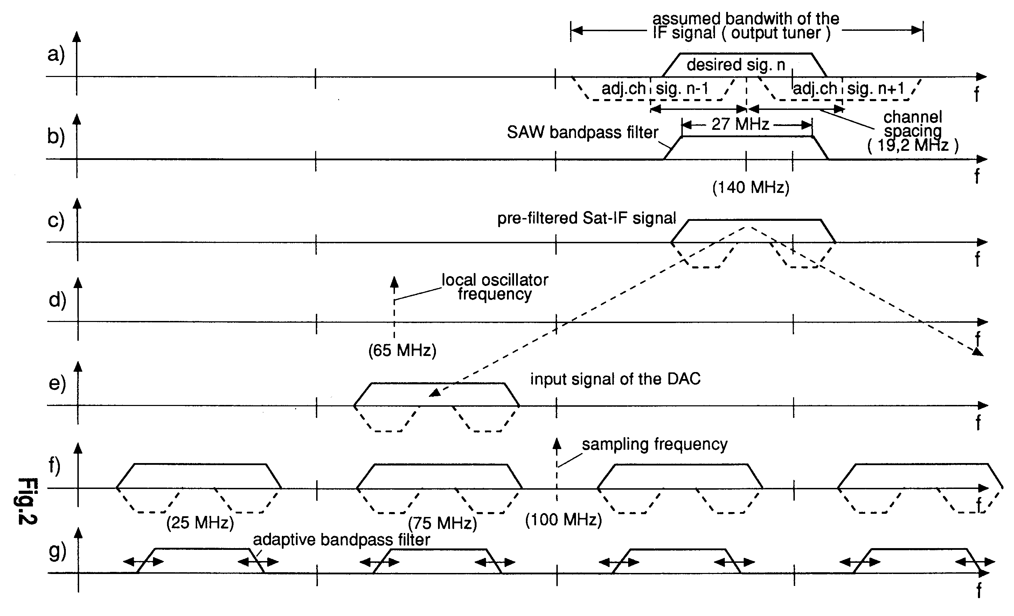

In the following the operation of said circuit will now be described in combination with Fig. 2.

At first the tuner output signal passes through the SAW filter 1 with a centre frequency of 140 MHz which suppresses a great deal of the adjacent channel signal components (see Fig. 2a, 2b and 2c). This is an important issue because the demodulator input is in general composed of the useful signal plus the co-channel and two adjacent channel interfering signals. The succeeding mixer stage 2 is operated with a local oscillator frequency between 60 and 70 MHz which realizes a frequency transposition into an IF signal of around 75 MHz (see Fig. 2d and 2e). The down-converted If signal then goes into AGC amplifier 5 with an internal bandpass limitation before the IF signal enters the input of A/D-converter 7. The AGC amplifier 5 has to make sure that the full dynamic range of the A/D-converter 7 is exploited to keep the quantizing noise to a minimum. The sampling frequency of the A/D-converter 7 should amount up to 100 MHz to allow sufficient large frequency spaces between the periodic spectra which could be occupied by the remainder of the adjacent channel signals, if the attenuation of the SAW filter 1 is not sufficient (see Fig. 2f). The A/D-converter 7 is operated in the sub-sampling mode, but this does not cause any aliasing problems because of the bandlimited input signal. Owing to the high sampling frequency, the effective dynamic resolution of the A/D-converter 7 may be somewhat reduced with respect to the nominal resolution. It is expected that due to the FM modulation the distortions can be neglected. The following bandpass filter 8 (see Fig. 2g) with an adaptively controlled bandwidth selects the desired signal with a minimal remainder of the adjacent channel signals. The FM demodulator 9 converts the IF signal into the CVBS signal and the subcarrier modulated sound signals, which have to be separated by lowpass and bandpass filters. Especially for the succeeding colour decoding part the sampling rate should be adapted to its clock frequency. The lowpass filter is, therefore, also used as sampling rate converter.

The DBS-band planning was laid down in the WARC '77 specification. It fixes a maximum signal bandwidth of 27 MHz, and the transponder bandwidth of DBS satellites have been designed accordingly. Therefore, it can be assumed a signal bandwidth of about 27 MHz as a stable specification for a D-DBS system allowing a net data rate of around 40 Mbits/s which is more than foreseen in the Direct TV proposal. This figure implies that something like a TCM-8 PSK modulation is used instead of any amplitude modulation schemes (like 16 QAM) which represents a bandwidth- but not power efficient modulation scheme. This point is quite important when a highly non-linear channel like the satellite transponder is used.

For the reception of digitally transmitted video signals the analogue pre-processing blocks can be kept. In the digital part a quadrature mixer and a special carrier regenerator have to be added in order to demodulate QPSK modulated signals. The carrier regenerator can be controlled by the digital QPSK demodulator which is not depicted in Fig. 1. The quadrature demodulator is followed by lowpass filters to produce an in phase and a quadrature symbol pattern at the output. The digital quadrature demodulation offers the advantage that it can be realized without any phase and amplitude matching problems between the I an Q channel. Furthermore, this architecture needs only one A/D-converter instead of two in the classical QPSK demodulator or even three, if also the digitizing of the analog FM transmission is taken into account.

## Claims

1. Broadcast receiver adapted for analogue and digital transmitted signals using FM-modulation and QPSK-modulation, said signals being converted into an analogue IF-signal, **characterized in that** said IF signal is fed to a frequency down converter (2) having its output connected to an A/D-converter (7) working with subsampling and having its output connected to an FM-demodulator (9) and a QPSK-demodulator (12, 13) both working in digital signal processing technique.

2. Receiver according to claim 1, **characterized in that** the A/D-converter (7) operates with a sampling frequency of about 100 MHz.

3. Receiver according to claim 1, **characterized in that** the sampling frequency has such a value that two spectra of the signal lie below said sampling frequency.
